(19) Europäisches Patentamt
European Patent Office
Office européen des brevets

(11) **EP 2 992 337 B1**

(12) **EUROPÄISCHE PATENTSCHRIFT**

(45) Veröffentlichungstag und Bekanntmachung des Hinweises auf die Patenterteilung:
**13.03.2019 Patentblatt 2019/11**

(21) Anmeldenummer: **14724022.0**

(22) Anmeldetag: **29.04.2014**

(51) Int Cl.:
***G01R 15/20*** (2006.01)   ***H01F 21/08*** (2006.01)
***G01R 33/02*** (2006.01)

(86) Internationale Anmeldenummer:
**PCT/EP2014/058682**

(87) Internationale Veröffentlichungsnummer:
**WO 2014/177538 (06.11.2014 Gazette 2014/45)**

(54) **VERFAHREN UND VORRICHTUNG ZUR ÜBERWACHUNG UND STROMMESSUNG AN EINER MAGNETISCH VORGESPANNTEN DROSSEL**

METHOD AND DEVICE FOR MONITORING AND MEASURING A CURRENT ON A MAGNETICALLY BIASED CHOKE

PROCÉDÉ ET DISPOSITIF POUR LA SURVEILLANCE ET LA MESURE DE COURANT D'UNE BOBINE SOUMISE À UNE PRÉCONTRAINTE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.04.2013 DE 102013104402**

(43) Veröffentlichungstag der Anmeldung:
**09.03.2016 Patentblatt 2016/10**

(73) Patentinhaber: **SMA Solar Technology AG**
**34266 Niestetal (DE)**

(72) Erfinder: **FRIEBE, Jens**
**34246 Vellmar (DE)**

(74) Vertreter: **Lahnor, Peter et al**
**SMA Solar Technology AG**
**Corporate Intellectual Property Management**
**Sonnenallee 1**
**34266 Niestetal (DE)**

(56) Entgegenhaltungen:
DE-A1-102010 062 237    DE-A1-102011 000 980
DE-B1- 2 827 601

**Beschreibung**

## TECHNISCHES GEBIET DER ERFINDUNG

Die Erfindung bezieht sich auf ein Verfahren zur Messung eines Drosselstroms durch eine Drossel, wobei an einem gegenüber der Drossel festen Ort eine Flussdichte eines von der Drossel ausgehenden Magnetfelds fortlaufend mit einer Abtastrate gemessen wird und wobei der aktuelle Drosselstrom aus den aktuellen Messwerten der Flussdichte bestimmt wird. Weiterhin bezieht sich die vorliegende Erfindung auf eine Vorrichtung mit einer Drossel, mit einem an einem gegenüber der Drossel festen Ort angeordneten Magnetfeldsensor, der eine Flussdichte eines von der Drossel ausgehenden Magnetfelds fortlaufend misst, und mit einer Auswerteeinrichtung, die den aktuellen Drosselstrom aus den aktuellen Messwerten der Flussdichte bestimmt.

Die magnetische Flussdichte B steht über die Gleichung $B = \mu * \mu_0 * H$ mit der Feldstärke H des Magnetfelds am selben Ort in Beziehung, wobei $\mu$ die magnetische Permeabilität des Materials ist, durch das sich das Magnetfeld erstreckt, und wobei $\mu_0$ eine Konstante ist. Als Maß für die Flussdichte des Magnetfelds kann bei dem Verfahren daher auch auf die Feldstärke des Magnetfelds an dem gegenüber der Drossel festen Ort abgestellt werden. (Um bei einer Messung mit dem Hallsensor (Permeabilität $\mu$ = 1) auf die Magnetfeldstärke H am gleichen Ort zu schließen, muss streng genommen bei Umrechnung der gemessenen Flussdichte B die Permeabilität von Luft ($\mu$Luft = 1 + 4*10$^{-7}$) und nicht die Permeabilität des Hallsensormaterials verwendet werden, sofern man die Magnetfeldstärke H in Luft berechnen will. Hintergrund ist die Stetigkeit der Normalkomponente von B an der Grenzfläche zweier Materialien mit unterschiedlicher Permeabilität.)

## STAND DER TECHNIK

Aus der CN 2876787 Y sind ein Verfahren der eingangs beschriebenen Art, das dem Oberbegriff des unabhängigen Patentanspruchs 1 entspricht, und eine Vorrichtung der eingangs beschriebenen Art, die dem Oberbegriff des unabhängigen Patentanspruchs 7 entspricht, bekannt. Konkret betrifft dieses Dokument einen Stromsensor für einen Strom durch einen Leiter. Der Leiter ist auf einen C-förmigen Kern gewickelt, in dessen Luftspalt ein auf einer Leitplatte montierter Hallsensor angeordnet ist. Der Strom durch den Leiter magnetisiert den Kern. Der magnetische Fluss durch den Kern setzt sich durch den Hallsensor auf der Leiterplatte fort. Die von dem Magnetfeld beziehungsweise von dessen magnetischer Flussdichte in dem Hallsensor erzeugte Spannung ist ein Maß für die magnetische Flussdichte und damit für den Strom durch den Leiter.

Aus der WO 2011/029018 A2 ist eine Messung des Stroms durch eine Leistungsleitung bekannt. Dazu wird die Leistungsleitung von einem C-förmigen Kern umgeben, auf den eine Kompensationsspule gewickelt ist und in dessen Luftspalt ein Hallsensor angeordnet ist. Ein Kompensationsstrom durch die Spule wird derart geregelt, dass der von dem Strom durch die Leistungsleitung in dem Kern induzierte und von dem Hallsensor erfasste magnetische Fluss verschwindet. Der derart geregelte Kompensationsstrom ist ein direktes Maß für den in der Leistungsleitung fließenden Strom.

Aus der DE 103 17 215 A1 ist ein Verfahren zur Qualitätsbestimmung von Dauermagneten bekannt. Der Dauermagnet wird relativ zu einem Aufnahmesensor bewegt. Hierbei wird die Ist-Magnetisierung in Form einer Feldstärken-Kurve ermittelt. Ein etwaiger Fehler des Dauermagneten in seinem Arbeitsbereich wird durch Vergleich der Feldstärken-Kurve mit einer Ideal-Kurve bestimmt.

Aus der DE 10 2011 000 980 A1 ist eine Drossel mit dynamischer Vormagnetisierung bekannt. Die Drossel weist eine Drosselwicklung, einen Kern, einen Permanentmagneten zur Vormagnetisierung des Kerns und eine Magnetisierungseinrichtung zur Einstellung einer gewünschten Magnetisierung des Permanentmagneten auf. Die Magnetisierungseinrichtung kann dazu verwendet werden, die Vormagnetisierung des Kerns den Betriebsbedingungen der Drossel anzupassen. Weiterhin ist eine Magnetisierungserfassungseinrichtung vorgesehen, die die Magnetisierung des Permanentmagneten der Drossel erfasst. Diese Magnetisierungserfassungsvorrichtung überwacht den Zeitverlauf eines Drosselstroms durch die Drosselwicklung auf Anzeichen einer unerwünschten Sättigung des Kerns. So kann festgestellt werden, ob die Magnetisierung des Permanentmagneten zurückgegangen ist oder aus anderen Gründen nicht mehr passend ist.

Das typische Ziel einer magnetischen Vorspannung einer Drossel ist es, ihren wirksamen Arbeitsbereich, in dem es nicht zu einer magnetischen Sättigung ihres Kerns kommt, für einen nur in einer Richtung fließenden Drosselstrom zu erweitern.

Aus der DE 10 2010 062 237 A1 ist ein Verfahren zum Kalibrieren eines Magnetfeldsensors mit einem Permanentmagneten bekannt. Das Verfahren umfasst das Anlegen eines ersten Magnetfelds mit einer ersten Stärke an den Magnetfeldsensor und das Auslesen einer ersten Antwortspannung sowie das Anlegen eines zweiten Magnetfelds mit einer zweiten Stärke an den Magnetfeldsensor und das Auslesen einer zweiten Antwortspannung. Weiterhin wird die Empfindlichkeit des Magnetfeldsensors auf der Basis der Differenz der ersten und der zweiten Magnetfeldstärke und der Differenz der ersten und der zweiten Antwortspannung ermittelt. Daraufhin wird die Nutzfeldstärke des Permanentmagneten auf der Basis der ermittelten Empfindlichkeit ermittelt. Auf diese Weise wird die Nutzfeldstärke des Permanentmagneten während des Betriebs des Magnetfeldsensors bestimmt. Für eine Spule ist das erzeugte Magnetfeld proportional zum Strom in der Spule. So kann über eine Änderung des Stroms in der Spule und die dabei gemessen Antwortspannungen auf die Nutzfeldstärke des Permanentmagneten zurückgeschlossen werden.

Aus der JP S62-163974 A ist ein Stromsensor bekannt, bei dem eine Offsetspannung eines Hallelements durch Mittel kompensiert wird, die ein magnetisches Hilfsfeld erzeugen. Diese Mittel umfassen eine Hilfsspule. Der durch die Hilfsspule fließende Strom wird bei einem zu messenden Strom von null so eingestellt, dass die Offsetspannung auf null gebracht wird.

DE2827601 offenbart ein Verfahren zur kontaktlosen Messung von Gleich- und Wechselströmen unter Verwendung eines Eisenkerns mit Luftspalt mit einer von einem Steuerstrom durchflossenen Feldplatte und einer von einem Messstrom durchflossenen Spule und einer weiteren Spule, die auf dem Eisenkern angeordnet ist und von einem Vormagnetisierungsstrom durchflossen wird, wobei die Durchflutung in kurzen zeitlichen Abständen in genau definiertem Maße verändert wird, die sich dabei ergebenden Ist-Änderungen der Feldplattenspannung mit Soll-Änderungen verglichen und sich etwa ergebende Abweichungen durch Änderung des Steuerstromes der Feldplatte oder des Vormagnetisierungsstromes ausgeregelt werden.

## AUFGABE DER ERFINDUNG

Der Erfindung liegt die Aufgabe zugrunde, ein besonders effizientes Verfahren und eine besonders effiziente Vorrichtung zur Überwachung und Strommessung an einer magnetisch vorgespannten Drossel bereitzustellen.

## LÖSUNG

Die Aufgabe der Erfindung wird durch ein Verfahren mit den Merkmalen des unabhängigen Patentanspruchs 1 und eine Vorrichtung mit den Merkmalen des unabhängigen Patentanspruchs 7 gelöst. Bevorzugte Ausführungsformen des erfindungsgemäßen Verfahrens und der erfindungsgemäßen Vorrichtung sind in den abhängigen Patentansprüchen definiert.

## BESCHREIBUNG DER ERFINDUNG

Bei einem erfindungsgemäßen Verfahren zur Messung eines Drosselstroms durch eine Drossel wird an einem gegenüber der Drossel festen Ort eine Flussdichte eines von der Drossel ausgehenden Magnetfelds fortlaufend mit einer Abtastrate gemessen. Aus den Messwerten der Flussdichte bei während der Verwendung der Drossel auftretendem, bekanntem Drosselstrom wird eine magnetische Vorspannung der Drossel ermittelt, wobei der Drosselstrom (I) nur in größeren zeitlichen Abständen als dem Kehrwert der Abtastrate bei der Messung der Flussdichte (B) bekannt ist; und der aktuelle Drosselstrom wird unter Berücksichtigung der ermittelten magnetischen Vorspannung aus den aktuellen Messwerten der Flussdichte bestimmt. Die Messungen der Flussdichte dienen also einem doppelten Zweck, nämlich der Erfassung und damit auch der Überwachung der magnetischen Vorspannung der Drossel einerseits und der Messung des aktuellen Drosselstroms durch die Drossel andererseits. Die Messwerte der Flussdichte des von der Drossel ausgehenden Magnetfelds hängen von beiden Faktoren, d. h. der magnetischen Vorspannung und dem aktuellen Drosselstrom ab. Die magnetische Vorspannung kann jedoch als prinzipiell, d. h. zumindest für gewisse Zeiträume ohne das Auftreten besonderer Ereignisse als konstant angenommen werden. Sie kann daher punktuell unter der Randbedingung bekannten Drosselstroms bestimmt und dann berücksichtigt werden, wenn in der Folge der aktuelle Drosselstrom aus den aktuellen Messwerten der Flussdichte ermittelt wird.

Konkret kann die magnetische Vorspannung der Drossel aus den Messwerten der Flussdichte bei dem bekannten Drosselstrom in um mindestens einen Faktor 10 größeren zeitlichen Intervallen ermittelt werden, als der Drosselstrom unter Berücksichtigung der ermittelten magnetischen Vorspannung aus den aktuellen Messwerten der Flussdichte bestimmt wird. Oft sind noch viel größere zeitliche Intervalle ausreichend, um die magnetische Vorspannung der Drossel aus den Messwerten der Flussdichte bei dem bekannten Drosselstrom zu ermitteln. Die minimalen Intervalle, in denen die Vorspannung der Drossel aus den Messwerten der Flussdichte bei dem bekannten Drosselstrom ermittelt werden kann, hängen davon ab, wann der Drosselstrom bekannt ist. Die minimalen Intervalle, in denen der Drosselstrom unter Berücksichtigung der ermittelten magnetischen Vorspannung aus den aktuellen Messwerten der Flussdichte bestimmt werden kann, sind gleich dem Kehrwert der Abtastrate, mit der die Flussdichte des von der Drossel ausgehenden Magnetfelds fortlaufend gemessen wird.

Es versteht sich, dass es bei der erfindungsgemäßen Bestimmung der magnetischen Vorspannung nicht auf die Bestimmung eines absoluten Werts der hierdurch bewirkten Magnetisierung eines Kerns der Drossel ankommt. Vielmehr ist die Bestimmung der Auswirkung der magnetischen Vorspannung auf die Flussdichte des von der Drossel ausgehenden Magnetfelds an dem gegenüber der Drossel festen Ort ausreichend. Ebenso reicht es bei der Ermittlung des Drosselstroms aus den aktuellen Messwerten der Flussdichte aus, diese Auswirkung der magnetischen Vorspannung als Offset eines allein von dem Drosselstrom hervorgerufenen Signalanteils am Ort der Messung zu berücksichtigen. Hierbei ist jedoch zu beachten, dass die Flussdichte des von der Drossel am Ort der Messung erzeugten Magnetfelds, also des Streufelds der Drossel, mit zunehmendem Abstand von der Drossel und dabei auch abhängig von der Richtung des Abstands abnimmt. Daher ist der durch die magnetische Vorspannung hervorgerufene Offset, wie auch der allein vom Drosselstrom verursachte Signalanteil, abhängig vom Ort der Messung.

Der Drosselstrom durch die Drossel, der zum Ermitteln der magnetischen Vorspannung der Drossel bekannt sein muss, kann bei dem erfindungsgemäßen Verfahren direkt gemessen werden. Dies kann aber mit viel geringerem Aufwand geschehen, als die Messung der magnetischen Flussdichte zur Messung des aktuellen Drosselstroms. Insbesondere kann die zusätzliche direkte Messung des Drosselstroms mit einer um mindestens einen Faktor 10 niedrigeren Abtastrate als bei der Messung der magnetischen Flussdichte erfolgen. Auch eine absolute Genauigkeit, mit der die zusätzliche direkte Messung des Drosselstroms erfolgt, braucht keinen hohen Anforderungen zu genügen. Vielmehr reicht eine hohe relative Genauigkeit aus, das heißt eine hohe Genauigkeit, mit der das Verhältnis von zwei Drosselströmen bestimmt wird. Die Bestimmung eines genauen Absolutwertes des Drosselstroms kann dann mit Hilfe einer einmaligen Kalibrierung mit einem absolut genauen Stromsensor erfolgen. Dieser Sensor muss aber kein ständiger Bestandteil der Vorrichtung sein.

Im einfachsten Fall wird die magnetische Vorspannung der Drossel aus den Messwerten der magnetischen Flussdichte bei einem Drosselstrom von null ermittelt. Bei einem Drosselstrom von null beruht das von der Drossel ausgehende Magnetfeld, also das magnetische Streufeld der Drossel, allein auf ihrer magnetischen Vorspannung. Jedoch mag sich ein Drosselstrom von null im laufenden Betrieb einer Drossel nicht problemlos einstellen lassen, um die magnetische Vorspannung in dem laufenden Betrieb zu überwachen. Dies ist beispielsweise dann der Fall, wenn die Drossel in einem DC/DC-Wandler eingesetzt wird, der nur an eine kleine Ausgangskapazität beziehungsweise ausgangsseitig an eine kleine Kapazität eines DC-Zwischenkreises angeschlossen ist. In diesem Fall führt schon eine kurzzeitige Änderung des Drosselstroms zu einer signifikanten und ggf. nicht tolerierbaren Änderung der Spannung der Ausgangskapazität beziehungsweise des DC-Zwischenkreises. In einer Ausführungsform des erfindungsgemäßen Verfahrens wird daher die magnetische Vorspannung der Drossel aus den Messwerten der magnetischen Flussdichte bei zwei unterschiedlichen Drosselströmen ermittelt, die in einem bekannten Verhältnis zueinander stehen. Auch bei Unkenntnis der absoluten Größe dieser unterschiedlichen Drosselströme kann daraus auf den Drosselstrom null extrapoliert werden. So kann die magnetische Vorspannung der Drossel auch ohne Anfahren eines Drosselstroms von null bestimmt werden. Wird hingegen die Drossel beispielsweise in einem DC/DC-Wandler eingesetzt, der eine große Kapazität an seinem Ausgang aufweist, so kann eine kurzzeitiges Herbeiführen eines Drosselstroms von null durchaus tolerierbar sein, da eine hierdurch erzeugte Spannungsschwankung an der großen ausgangsseitigen Kapazität nicht ins Gewicht fällt und daher vernachlässigbar, zumindest jedoch tolerierbar ist.

Sowohl ein Drosselstrom von null als auch unterschiedliche, in einem bekannten Verhältnis zueinander stehende Drosselströme können nicht nur durch direktes Messen dieser Drosselströme bekannt sein, sondern auch aufgrund des bekannten Betriebszustands einer den Drosselstrom hervorrufenden Einrichtung, wie beispielsweise eines Wechselrichters. Allgemein können Zeitpunkte, zu denen der Drosselstrom null ist oder unterschiedliche Drosselströme vorliegen, die in einem bekannten Verhältnis zueinander stehen, aus Bedingungen abgeleitet werden, die im laufenden Betrieb der Drossel vorliegen. Konkret kann die Drossel beispielsweise in einem DC/DC-Wandler, z. B. einem Hochsetzsteller eines Wechselrichters eingesetzt werden, der zumindest zweitweise in einem Lückbetrieb betrieben wird. Es ist weiterhin möglich, dass bei dem DC/DC-Wandler des Wechselrichters ein Drosselstrom von null zu ausgewählten Zeitpunkten gezielt herbeigeführt wird. Insbesondere kann der Wechselrichter Zeitpunkte signalisieren, zu denen der Drosselstrom null ist, oder unterschiedliche Zeitpunkte, zu denen die hervorgerufenen Drosselströme in einem bekannten Verhältnis zueinander stehen, um aus den zu diesen Zeitpunkten gemessenen Flussdichten des von der Drossel hervorgerufenen Magnetfelds die magnetische Vorspannung der Drossel zu bestimmen. Vorteilhafterweise werden im letzten Fall die Zeitpunkte so gewählt, dass ein Zeitraum zwischen zwei Zeitpunkten, an denen eine Messung erfolgt und die gemeinsam für die Bestimmung der magnetischen Vorspannung der Drossel herangezogen werden, möglichst kurz ist. Auf diese Weise werden das Risiko und der Einfluss einer potentiell schleichend und in der Regel langsam erfolgenden Änderung der magnetischen Vorspannung zwischen den beiden Messungen minimiert.

Bei dem erfindungsgemäßen Verfahren wird die Ermittlung der magnetischen Vorspannung der Drossel vorzugsweise nach definierten Ereignissen wiederholt. Zu solchen definierten Ereignissen kann der Ablauf einer bestimmten Zeit zählen. Insbesondere kann hierzu aber auch die Beaufschlagung der Drossel mit hohen Drosselströmen oder stark schwankenden Drosselströmen zählen, mit denen die Gefahr einer Veränderung der Quelle der Vormagnetisierung der Drossel verbunden ist. Zu den Ereignissen, nach denen die Ermittlung der magnetischem Vorspannung der Drossel wiederholt wird, zählt unbedingt jeder Vorgang, mit dem die magnetische Vorspannung gezielt modifiziert, wie beispielsweise aufgefrischt wird. Sinnvollerweise wird für die Bestimmung des aktuellen Drosselstroms aus den Messungen der Flussdichte unter Berücksichtigung der magnetischen Vorspannung die jeweils zuletzt bestimmte magnetische Vorspannung genutzt. Gleichfalls ist es möglich, dass sich die zu berücksichtigende magnetische Vorspannung aus einem Mittelwert bzw. aus einem extrapolierten Wert mehrerer zuletzt bestimmter magnetischer Vorspannungen ergibt.

Die Quelle der magnetischen Vorspannung der Drossel kann bei dem erfindungsgemäßen Verfahren einen oder mehrere Permanentmagnete aufweisen. Grundsätzlich kann die Quelle der Vormagnetisierung aber auch beispielsweise eine mit einem konstanten Strom durchflossene zusätzliche Wicklung der Drossel oder dergleichen sein.

Bei dem erfindungsgemäßen Verfahren kann die Flussdichte des von der Drossel ausgehenden Magnetfelds an mehreren gegenüber der Drossel festen Orten fortlaufend gemessen werden. Ziel kann dabei eine genauere Ermittlung des Drosselstromes wie auch der magnetischen Vorspannung der Drossel sein, auch wenn diese nur von einer einzigen Quelle ausgeht. Wenn mehrere Quellen für die magnetische Vorspannung vorhanden sind, beispielsweise mehrere Permanentmagnete, können diese durch Messung der Flussdichte des Magnetfelds an mehreren Orten einzeln voneinander überwacht werden. Eine Messung der Flussdichte des Magnetfelds an mehreren Orten ist auch dann sinnvoll, wenn die Drossel mehrere Drosselwicklungen aufweist, durch die jeweils ein Drosselstrom fließt. Für jeden dieser Drosselströme ist mindestens die Flussdichte an einem geeigneten zusätzlichen Ort zu messen, um ihn separat erfassen zu können. In diesem Fall befindet sich der zusätzliche Ort vorteilhafterweise möglichst nahe an den jeweiligen Quellen der magnetischen Vorspannung beziehungsweise möglichst nahe an Wicklungsenden der Drosselwicklungen, da dort die Feldstäke des betreffenden magnetischen Streufeldes vergleichsweise hoch ist und somit bei einer Messung ein möglichst großes Signal / Rausch - Verhältnis gewährleistet ist.

Bei dem erfindungsgemäßen Verfahren kann die Temperatur eines Kerns der Drossel und/oder einer Quelle der magnetischen Vorspannung der Drossel und/oder eines zum Messen der magnetischen Flussdichte verwendeten Magnetfeldsensors gemessen und bei der Ermittlung der magnetischen Vorspannung und/oder des aktuellen Drosselstroms aus den aktuellen Messwerten der Flussdichte berücksichtigt werden. So können temperaturabhängige Effekte bei diesen Bauteilen kompensiert werden.

Eine erfindungsgemäße Vorrichtung weist eine Drossel mit einer Quelle für eine magnetische Vorspannung, einen an einem gegenüber der Drossel festen Ort angeordneten Magnetfeldsensor, der eine Flussdichte eines von der Drossel ausgehenden Magnetfelds fortlaufend mit einer Abtastrate misst, und eine Auswerteeinrichtung auf, die aus den Messwerten der magnetischen Flussdichte bei im laufenden Betrieb der Drossel auftretendem, bekanntem Drosselstrom eine magnetische Vorspannung der Drossel ermittelt, wobei der Drosselstrom nur in größeren zeitlichen Abständen als dem Kehrwert der Abtastrate bei der Messung der Flussdichte bekannt ist, und den aktuellen Drosselstrom unter Berücksichtigung der ermittelten magnetischen Vorspannung aus den aktuellen Messwerten der Flussdichte bestimmt.

Die Auswerteeinrichtung kann die magnetische Vorspannung der Drossel aus den Messwerten der Flussdichte bei dem bekannten Drosselstrom in um mindestens einen Faktor 10 größeren zeitlichen Intervallen ermitteln, als sie den Drosselstrom unter Berücksichtigung der ermittelten magnetischen Vorspannung aus den aktuellen Messwerten der Flussdichte bestimmt.

Damit der Auswerteeinrichtung ein bekannter Drosselstrom zur Verfügung steht, kann ein zusätzlicher Stromsensor vorgesehen sein, der mit einer um mindestens einen Faktor 10 niedrigeren Abtastrate als der Magnetfeldsensor den Drosselstrom direkt misst und an den auch keine besonderen Anforderungen bezüglich der absoluten Genauigkeit bestehen, solange er den Drosselstrom mit hoher relativer Genauigkeit gegenüber einem anderen bekannten Drosselstrom bestimmt. Ebenso wie das erfindungsgemäße Verfahren ist die erfindungsgemäße Vorrichtung jedoch in der Lage, den aktuellen Drosselstrom mit sehr hoher Zeitauflösung und hoher absoluter Genauigkeit zu erfassen. Eine maximale Genauigkeit wird bei einer genauen Kalibrierung des Magnetfeldsensors an der jeweiligen Drossel erreicht.

Statt über einen zusätzlichen Stromsensor zu verfügen, kann die Auswerteeinrichtung auch ein Signal von extern empfangen, aus dem sie Zeitpunkte ermittelt, an denen der Drosselstrom null ist oder unterschiedliche Drosselströme in einem bekannten Verhältnis zueinander stehen. Solche Signale kann sie beispielsweise von einem Wechselrichter empfangen, der den Drosselstrom hervorruft.

Weiterhin kann die Auswerteeinrichtung einen Ereignisdetektor aufweisen und beim Detektieren eines vorgegebenen Ereignisses die Ermittlung der Vorspannung der Drossel wiederholen. Hierbei zählt es auch zu der Erfindung, wenn das Ereignis über eine externe Einrichtung detektiert oder auch gesteuert wird und diese Einrichtung der Auswerteeinheit das Ereignis signalisiert. Eine solche Signalisierung kann über eine Kommunikationsschnittstelle von der externen Einrichtung an die Auswerteeinheit - z. B. kabelgebunden oder per Funk - kommuniziert werden. In diesem Fall ist es ausreichend, wenn die Auswerteeinheit eine entsprechende Empfangseinheit zum Empfang des Kommunikationssignales aufweist. Die hier vorgebbaren Ereignisse wurden bereits im Zusammenhang mit dem erfindungsgemäßen Verfahren beispielhaft erläutert.

Der Magnetfeldsensor der erfindungsgemäßen Vorrichtung kann insbesondere ein Hallsensor sein. Es können auch mehrere Magnetfeldsensoren vorgesehen sein, die die Flussdichte des Magnetfelds an mehreren gegenüber der Drossel festen Orten fortlaufend messen.

Die Quelle für magnetische Vorspannung der Drossel kann insbesondere einen Permanentmagneten umfassen. Es können auch mehrere Permanentmagnete vorhanden sein. Weiterhin kann die Quelle für magnetische Vorspannung auch eine mit einem festen Strom durchflossene Spule oder dergleichen aufweisen.

Die erfindungsgemäße Vorrichtung kann mindestens einen Temperatursensor aufweisen, der die Temperatur eines Kerns der Drossel und/oder der Quelle der magnetischen Vorspannung und/oder des Magnetfeldsensors misst und der an die Auswerteeinrichtung angeschlossen ist. Die Auswerteeinrichtung kann die mit dem Temperatursensor gemessene Temperatur bei der Ermittlung der magnetischen Vorspannung und/oder des aktuellen Drosselstroms aus den aktuellen Messwerten der Flussdichte berücksichtigen.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

## KURZBESCHREIBUNG DER FIGUREN

Die Erfindung wird im Folgenden anhand von Ausführungsbeispielen unter Bezugnahme auf die beigefügten Zeichnungen näher erläutert und beschrieben.

**Fig. 1**     illustriert eine erste Ausführungsform einer erfindungsgemäßen Vorrichtung.

**Fig. 2**     illustriert eine Variante der Vorrichtung gemäß Fig. 1.

**Fig. 3**     illustriert eine zweite Ausführungsform der erfindungsgemäßen Vorrichtung; und

**Fig. 4**     ist eine schematische Auftragung von Messwerten einer magnetischen Flussdichte, die bei dem erfindungsgemäßen Verfahren gemessen wird, über dem zugehörigen Drosselstrom.

## FIGURENBESCHREIBUNG

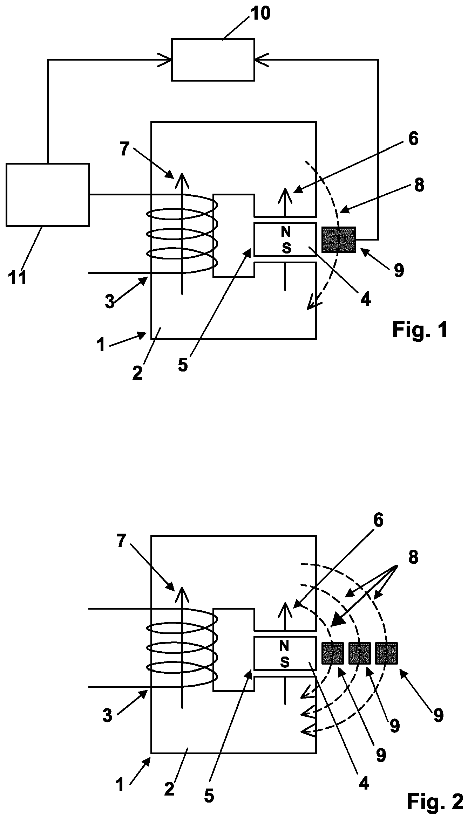

In **Fig. 1** ist eine Drossel 1 mit einer auf einem Kern 2 vorgesehenen Drosselwicklung 3 dargestellt. Die Drossel 1 ist durch einen Permanentmagneten 4 magnetisch vorgespannt, der in einem Luftspalt 5 des C-förmigen Kerns 2 angeordnet ist und den Kern 2 vormagnetisiert. Die durch einen Pfeil angedeutete magnetische Vorspannung 6 oder Vormagnetisierung ist dabei einer Magnetisierung 7 entgegengesetzt, die durch eine Bestromung der Drosselwicklung 3 mit einem in fester Richtung fließenden Drosselstrom hervorgerufen wird und ebenfalls durch einen Pfeil symbolisiert ist. Hierdurch wird der effektive Arbeitsbereich der Drossel 1, bevor ihr Kern 2 magnetisch gesättigt wird, für den in fester Richtung fließenden Drosselstrom erweitert.

Das durch einen gestrichelten Pfeil angedeutete Magnetfeld 8 oder Streufeld neben dem Permanentmagneten 4 und dem Luftspalt 5 wird durch einen Magnetfeldsensor 9 erfasst. Hierbei kann es sich insbesondere um einen Hallsensor handeln. Der Magnetfeldsensor 9 misst an einem gegenüber der Drossel 1 festen Ort die dort lokal gegebene Flussdichte des von der Drossel 1 hervorgerufenen Magnetfelds 8. Dieses Magnetfeld 8 beruht sowohl auf der magnetischen Vorspannung 6 als auch auf der Magnetisierung 7 infolge des durch die Drosselwicklung 3 fließenden Drosselstroms. Die von dem Magnetfeldsensor 9 fortlaufend gemessenen Flussdichten werden von einer Auswerteeinrichtung 10 sowohl bezüglich der magnetischen Vorspannung 6 als auch des aktuellen Drosselstroms durch die Drossel 3 ausgewertet. Dabei wird/werden zur Ermittlung der magnetischen Vorspannung 6 entweder der Messwert der Flussdichte bei einem Drosselstrom von null verwendet oder Messwerte, die bei unterschiedlichen Drosselströmen gemessen wurden, die in einem bekannten Verhältnis zueinander stehen, aber nicht absolut bekannt sein müssen. Geeignete Zeitpunkte für die Aufnahme dieser Messwerte erhält oder erfasst die Auswerteeinrichtung 10 von einer Einrichtung 11, die den Drosselstrom durch die Drosselwicklung 3 hervorruft.

Es ist bekannt, dass evtl. Temperaturänderungen einen Einfluss auf die Magnetisierung 7 des Kerns 2, wie auch auf die magnetische Vorspannung 6 der Drossel 1 haben können. Solche Temperatureffekte beeinflussen somit auch das von der Drossel ausgehende Magnetfeld 8 und dessen magnetische Flussdichte. Um einen dadurch hervorgerufenen Messfehler bei der Bestimmung des Drosselstromes als auch der magnetischen Vorspannung 6 der Drossel 1 zu eliminieren, zumindest jedoch zu minimieren, weist die Vorrichtung in einer vorteilhaften Ausgestaltung in unmittelbarer Nähe des Magnetfeldsensors 9, des Kerns 2 und/oder der Quelle der magnetischen Vorspannung - hier: des Permanentmagneten 4 - einen oder mehrere Temperatursensoren (in Fig. 1 nicht dargestellt) auf. Gegebenenfalls befindet sich der Temperatursensor auch in direktem Kontakt mit diesen Komponenten. Der Ausgang des Temperursensors ist mit der Auswerteeinrichtung 10 verbunden. Damit ist die Auswerteeinrichtung 10 in der Lage, eine rein temperaturbedingte Änderung eines Signales am Magnetfeldsensor 9, d. h. dem Messsignal, zu kompensieren. Auf diese Weise lässt sich die Genauigkeit der Messung vergrößern.

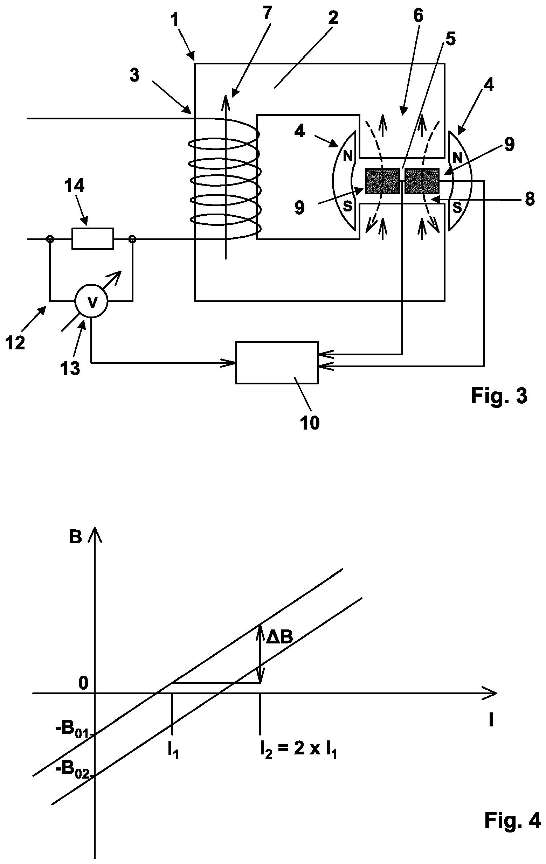

In Fig. 1 ist - wie auch in Fig. 2 und Fig. 3 - der Permanentmagnet 4 nicht in direktem Kontakt mit dem Kern 2 dargestellt. Vielmehr sind hier Spalte zwischen dem Permanentmagneten 4 und dem Kern 2 wiedergegeben. Bei einer bleibenden Befestigung des Permanentmagneten 4 an dem Kern 2 - bspw. durch einen Klebeprozess - lassen sich die Spalte zwischen beiden Komponenten auch rein fertigungstechnisch nicht vollständig vermeiden. Zum Zwecke der Befestigung können die Spalte beispielsweise mit einem magnetisch nicht aktiven Material wie einem geeigneten Klebstoff) ausgefüllt sein. Obwohl in den Fig. 1 bis 3 jeweils Spalte zwischen dem Permanentmagneten 4 und dem Kern 2 dargestellt sind, liegt es jedoch auch im Rahmen der Erfindung, dass der Permanentmagnet 4 passgenau - d. h. ohne resultierende Spalte - in den Luftspalt 5 des Kerns 2 eingepasst ist.

Fig. 2 illustriert die mit dem Permanentmagneten 4 magnetisch vorgespannte Drossel 1 zusammen mit mehreren Magnetfeldsensoren 9, die die magnetische Flussdichte des Magnetfelds 8 an verschiedenen Orten, d. h. hier in verschiedenen seitlichen Abständen zu dem Luftspalt 5 und dem darin angeordneten Permanentmagneten 4 erfassen. Mit Hilfe der mehreren Magnetfeldsensoren 9 kann die Messgenauigkeit bei der Erfassung der magnetischen Vorspannung 6 und auch des Drosselstroms durch die Drosselwicklung 3 erhöht werden. Zusätzlich ist es mit einer Anordnung mehrerer benachbarter Magnetfeldsensoren möglich, Messungen zu identifizieren, bei denen - aus welchen Gründen auch immer - eine externe Störung dem eigentlich interessierenden Magnetfeld der Drossel 1 eine zusätzliche Magnetfeldkomponente überlagert. Diese Überlagerung ändert das relative Verhältnis der Signalpegel der verschiedenen Magnetfeldsensoren 9 und kann somit erkannt werden.

Die in Fig. 3 gezeigte Vorrichtung weist eine durch zwei Permanentmagnete 4 magnetisch vorgespannte Drossel 1 auf. Dabei sind die Permanentmagnete 4 hier bogenförmig auf beiden Seiten des Luftspalts 5 angeordnet, während zwei Magnetfeldsensoren 9 in diesem Luftspalt 5 liegen. Die Magnetfeldsensoren 9 erfassen das Magnetfeld 8 in dem Luftspalt 5. Dabei ist jeder der Magnetfeldsensoren 9 einem der Permanentmagnete 4 zugeordnet, d. h. er erfasst den Anteil des Magnetfelds 8, der auf der magnetischen Vorspannung 6 durch den zugeordneten Permanentmagneten 4 beruht, mit höherer Empfindlichkeit. Neben den von den Magnetfeldsensoren 9 erfassten Flussdichten berücksichtigt die Auswerteeinrichtung 10 das Signal eines Stromsensors 12, der mit einem Voltmeter 13 die über einem Shuntwiderstand 14 aufgrund des Drosselstroms abfallende Spannung erfasst. Der Stromsensor 12 wird nur benötigt, um relative Größen des Drosselstroms zu wenigen Zeitpunkten zu erfassen. Aus den mit den Magnetfeldsensoren 9 fortlaufend erfassten Messwerten der magnetischen Flussdichte berechnet die Auswerteeinrichtung 10 hingegen fortlaufend und mit sehr hoher zeitlicher und absoluter Auflösung den Drosselstrom durch die Drosselwicklung 3. Die Auswerteeinrichtung 10 ist in der Lage, die so ermittelten Größen (Drosselstrom, magnetische Vorspannung) einer weiteren Einheit - beispielsweise einer übergeordneten Steuerung eines Wechselrichters (in Fig. 3 nicht dargestellt) zu übermitteln.

Fig. 4 illustriert die an einem festen Ort relativ zu einer magnetisch vorgespannten Drossel mit einem Magnetfeldsensor gemessene magnetische Flussdichte B als Funktion des Drosselstromes I in einem Diagramm. Dem Diagramm ist zu entnehmen, dass die magnetische Flussdichte B des von der magnetisch vorgespannten Drossel hervorgerufenen magnetischen Streufeldes einmal von dem Drosselstrom I und zum anderen von der magnetischen Vorspannung der Drossel abhängt. Da die magnetische Vorspannung der Drossel einer Magnetisierung aufgrund des Drosselstroms I entgegengerichtet ist, bewirkt die magnetische Vorspannung der Drossel im Magnetfeldsensor einen negativen Offset. Gemessen wird mit dem Magnetfeldsensor somit ein Signal, das eine Superposition der beiden Effekte - magnetische Vorspannung der Drossel und der allein durch den Drosselstrom I hervorgerufenen Magnetisierung der Drossel - darstellt.

Zur weiteren Erklärung des Sachverhaltes ist in Fig. 4 ein linearer Anstieg der Flussdichte mit dem Drosselstrom I angenommen. Experimentelle Ergebnisse zeigen, dass ein derartiger linearer Ansatz bei einem ungesättigten Kernmaterial der Drossel über einen vergleichsweise weiten Messbereich des Drosselstromes eine ausreichend gute Näherung der tatsächlichen Verhältnisse darstellt. Dargestellt sind zwei beispielhafte Verläufe der magnetischen Flussdichte $B(I)$ für zwei unterschiedliche magnetische Vorspannungen, die bei einem Drosselstrom $I = 0$ zu einer negativen Flussdichte $B(I = 0) = -B_{01}$ bzw. $B(I = 0) = -B_{02}$, d. h. einem magnetischen Fluss mit einer dem magnetischen Fluss aufgrund des Drosselstroms $I$ entgegen gesetzten Richtung führen. Die Flussdichte $-B_{01}$ bzw. $-B_{02}$ ist dabei ein unmittelbares Maß für die magnetische Vorspannung. Anders gesagt kann die magnetische Vorspannung ganz leicht bestimmt werden, wenn der Drosselstrom $I = 0$ ist. Häufig ergibt sich jedoch im laufenden Betrieb einer vormagnetisierten Drossel kein Drosselstrom von null, oder es ist aufgrund der zuvor erläuterten Gründe nicht tolerierbar, dass ein Drosselstrom von null auch nur kurzzeitig herbeigeführt wird. In diesem Fall kann die magnetische Vorspannung aber dadurch ermittelt werden, dass von den magnetischen Flussdichten $B(I_1)$ und $B(I_2)$ bei zwei Drosselströmen $I_1$ und $I_2$, die in einem festen Verhältnis zueinander stehen, auf die magnetische Flussdichte bei dem Drosselstrom $I = 0$ extrapoliert wird, ohne den stromlosen Zustand $I=0$ explizit herbeiführen zu müssen. Zum Beispiel kann aus dem Unterschied $\Delta B$ zwischen den Flussdichten $B(I_1)$ und $B(I_2)$ bei dem Drosselstrom $I_1$ und einem doppelt so großen Drosselstrom $I_2$ wie folgt auf die Flussdichte bei dem Drosselstrom von null zurückgeschlossen werden:

$$B(I = 0) = B(I_1) - \Delta B = B(I_1) - (B(I_2) - B(I_1)) = 2B(I_1) - B(I_2)$$

Wenn die magnetische Vorspannung in Form von $B(I = 0)$ bekannt ist, kann aus dem aktuellen Wert von $B(I)$ auf $I$ rückgeschlossen werden. Dabei kann statt eines in Fig. 4 gezeigten linearen Zusammenhangs auch eine für den Einzelfall bestimmte Kalibrierungskurve Verwendung finden. Dies gilt gleichermaßen auch für die Bestimmung der Vormagnetisierung.

## BEZUGSZEICHENLISTE

| | |
|---|---|
| 1 | Drossel |
| 2 | Kern |
| 3 | Drosselwicklung |
| 4 | Permanentmagnet |
| 5 | Luftspalt |
| 6 | magnetische Vorspannung |
| 7 | Magnetisierung |
| 8 | Streufeld |
| 9 | Magnetfeldsensor |
| 10 | Auswerteeinrichtung |
| 11 | Einrichtung |
| 12 | Stromsensor |
| 13 | Voltmeter |
| 14 | Shuntwiderstand |
| B | Flussdichte |
| I | Drosselstrom |

**Patentansprüche**

1. Verfahren zur Bestimmung eines Drosselstroms (I) durch eine Drossel (1), wobei an einem gegenüber der Drossel (1) festen Ort eine Flussdichte (B) eines von der Drossel (1) ausgehenden Magnetfelds (8) fortlaufend mit einer Abtastrate gemessen wird und wobei der aktuelle Drosselstrom (I) aus den aktuellen Messwerten der Flussdichte (B) bestimmt wird, **dadurch gekennzeichnet, dass** aus den Messwerten der Flussdichte (B) bei im laufenden Betrieb der Drossel (1) auftretendem, bekanntem Drosselstrom (I) eine magnetische Vorspannung der Drossel (1) ermittelt wird, wobei der Drosselstrom (I) nur in größeren zeitlichen Abständen als dem Kehrwert der Abtastrate bei der Messung der Flussdichte (B) bekannt ist, und dass der aktuelle Drosselstrom (I) unter Berücksichtigung der ermittelten magnetischen Vorspannung aus den aktuellen Messwerten der Flussdichte (B) bestimmt wird.

2. Verfahren nach Anspruch 1, **dadurch gekennzeichnet, dass** die magnetische Vorspannung der Drossel (1) aus den Messwerten der Flussdichte (B) bei dem bekannten Drosselstrom (I) in um mindestens einen Faktor 10 größeren zeitlichen Intervallen ermittelt wird, als der Drosselstrom unter Berücksichtigung der ermittelten magnetischen Vorspannung aus den aktuellen Messwerten der Flussdichte (B) bestimmt wird.

3. Verfahren nach einem der vorhergehenden Ansprüche, **dadurch gekennzeichnet, dass** die magnetische Vorspannung der Drossel (1) unter Verwendung der Messwerte der Flussdichte (B) bei einem Drosselstrom (I) von null ermittelt wird.

4. Verfahren nach einem der vorhergehenden Ansprüche, **dadurch gekennzeichnet, dass** die magnetische Vorspannung der Drossel (1) unter Verwendung der Messwerte der Flussdichte (B) bei zwei unterschiedlichen Drosselströmen ($I_1$, $I_2$) ermittelt wird, die in einem bekannten Verhältnis zueinander stehen.

5. Verfahren nach Anspruch 3 oder 4, **dadurch gekennzeichnet, dass** Zeitpunkte, zu denen der Drosselstrom (I) null ist oder die beiden unterschiedlichen Drosselströme ($I_1$, $I_2$) vorliegen, die in einem bekannten Verhältnis zueinander stehen, aus Bedingungen abgeleitet werden, die im laufenden Betrieb der Drossel (1) vorliegen.

6. Verfahren nach einem der vorhergehenden Ansprüche, **dadurch gekennzeichnet, dass** die Temperatur eines Kerns (2) der Drossel (1) und/oder einer Quelle der magnetischen Vorspannung (6) der Drossel (1) und/oder eines zum Messen der magnetischen Flussdichte verwendeten Magnetfeldsensors (9) gemessen und bei der Ermittlung der magnetischen Vorspannung und/oder des aktuellen Drosselstroms (I) aus den aktuellen Messwerten der Flussdichte (B) berücksichtigt wird.

7. Vorrichtung mit einer Drossel (1), mit einem an einem gegenüber der Drossel (1) festen Ort angeordneten Magnetfeldsensor (9), der eine Flussdichte (B) eines von der Drossel (1) ausgehenden Magnetfelds (8) fortlaufend mit einer Abtastrate misst, und mit einer Auswerteeinrichtung (10), die den aktuellen Drosselstrom (I) aus den aktuellen Messwerten der Flussdichte (B) bestimmt, **dadurch gekennzeichnet, dass** die Drossel (1) eine Quelle für magnetische Vorspannung aufweist und dass die Auswerteeinrichtung (10) aus den Messwerten der Flussdichte (B) bei im laufenden Betrieb der Drossel (1) auftretendem, bekanntem Drosselstrom (I) eine magnetische Vorspannung der Drossel (1) ermittelt, wobei der Drosselstrom (I) nur in größeren zeitlichen Abständen als dem Kehrwert der Abtastrate bei der Messung der Flussdichte (B) bekannt ist, und den aktuellen Drosselstrom (I) unter Berücksichtigung der ermittelten magnetischen Vorspannung aus den aktuellen Messwerten der Flussdichte (B) bestimmt.

8. Vorrichtung nach Anspruch 7, **dadurch gekennzeichnet, dass** die Auswerteeinrichtung (10) die magnetische Vorspannung der Drossel (1) aus den Messwerten der Flussdichte (B) bei dem bekannten Drosselstrom (I) in um mindestens einen Faktor 10 größeren zeitlichen Intervallen ermittelt, als sie den Drosselstrom unter Berücksichtigung der ermittelten magnetischen Vorspannung aus den aktuellen Messwerten der Flussdichte (B) bestimmt.

9. Vorrichtung nach Anspruch 7 oder 8, **dadurch gekennzeichnet, dass** ein Stromsensor (12) vorgesehen ist, der mit einer um mindestens einen Faktor 10 niedrigeren Abtastrate als der Magnetfeldsensor (9) den Drosselstrom (I) direkt misst.

10. Vorrichtung nach einem der Ansprüche 7 bis 9, **dadurch gekennzeichnet, dass** die Auswerteeinrichtung (10) ein Signal empfängt, aus dem sie Zeitpunkte ermittelt, zu denen der Drosselstrom (I) null ist oder unterschiedliche Drosselströme ($I_1$, $I_2$) in einem bekannten Verhältnis zueinander stehen.

11. Vorrichtung nach einem der Ansprüche 7 bis 10, **dadurch gekennzeichnet, dass** die Auswerteeinrichtung (10) einen Ereignisdetektor aufweist und bei Detektieren eines vorgegebenen Ereignisses die Ermittlung der magnetischen Vorspannung der Drossel (1) wiederholt.

12. Vorrichtung nach einem der Ansprüche 7 bis 11, **dadurch gekennzeichnet, dass** der Magnetfeldsensor (9) ein Hallsensor ist.

13. Vorrichtung nach einem der Ansprüche 7 bis 12, **dadurch gekennzeichnet, dass** mehrere Magnetfeldsensoren (9) vorgesehen sind, die die Flussdichte (B) des Magnetfelds (8) an mehreren gegenüber der Drossel (1) festen Orten fortlaufend messen.

14. Vorrichtung nach einem der Ansprüche 7 bis 13, **dadurch gekennzeichnet, dass** die Quelle für magnetische Vorspannung einen Permanentmagneten (4) umfasst.

**15.** Vorrichtung nach einem der Ansprüche 7 bis 14, **dadurch gekennzeichnet, dass** mindestens ein Temperatursensor vorgesehen ist, der die Temperatur eines Kerns (2) der Drossel (1) und/oder der Quelle der magnetischen Vorspannung (6) und/oder des Magnetfeldsensors (9) misst und der an die Auswerteeinrichtung (10) angeschlossen ist und dass die Auswerteeinrichtung (10) die mit dem Temperatursensor gemessene Temperatur bei der Ermittlung der magnetischen Vorspannung und/oder des aktuellen Drosselstroms (I) aus den aktuellen Messwerten der Flussdichte (B) berücksichtigt.

**Claims**

**1.** A method for determining a choke current (I) through a choke (1), wherein a flux density (B) of a magnetic field (8) originating from the choke (1) is consecutively measured at a sampling rate at a fixed location in relation to the choke (1), and wherein the actual choke current (I) is determined from the actual measurement values of the flux density (B), **characterized in that** a magnetic bias of the choke (1) is ascertained from the measurement values of the flux density (B) at a known choke current (I) occurring during operation of the choke (1), wherein the choke current (I) is known only at longer time intervals than the inverse value of the sampling rate during measurement of the flux density (B), and **in that** the actual choke current (I) is determined from the actual measurement values of the flux density (B) taking into account the ascertained magnetic bias.

**2.** The method as claimed in claim 1, **characterized in that** the magnetic bias of the choke (1) is ascertained from the measurement values of the flux density (B) at the known choke current (I) at time intervals which are longer by at least a factor of 10 than the time intervals at which the choke current is determined from the actual measurement values of the flux density (B) taking into account the ascertained magnetic bias.

**3.** The method as claimed in one of the preceding claims, **characterized in that** the magnetic bias of the choke (1) is ascertained using the measurement values of the flux density (B) at a choke current (I) of zero.

**4.** The method as claimed in one of the preceding claims, **characterized in that** the magnetic bias of the choke (1) is ascertained using the measurement values of the flux density (B) at two different choke currents ($I_1$, $I_2$) which are in a known ratio in relation to one another.

**5.** The method as claimed in claim 3 or 4, **characterized in that** points in time at which the choke current (I) is zero or the two different choke currents ($I_1$, $I_2$) which are in a known ratio in relation to one another are present are derived from conditions which are present during operation of the choke (1).

**6.** The method as claimed in one of the preceding claims, **characterized in that** the temperature of a core (2) of the choke (1) and/or of a source of the magnetic bias (6) of the choke (1) and/or of a magnetic field sensor (9) used to measure the magnetic flux density (B) is measured and is taken into account when ascertaining the magnetic bias and/or the actual choke current (I) from the actual measurement values of the flux density (B).

**7.** A device with a choke (1), the device comprising a magnetic field sensor (9) arranged at a fixed location in relation to the choke (1) and consecutively measuring a flux density (B) of a magnetic field (8), originating from the choke (1), at a sampling rate, and comprising an evaluation device (10) determining the actual choke current (I) from the actual measurement values of the flux density (B), **characterized in that** the choke (1) comprises a source for magnetic bias, and **in that** the evaluation device (10) ascertains a magnetic bias of the choke (1) from the measurement values of the flux density (B) at a known choke current (I) occurring during operation of the choke (1), wherein the choke current (I) is known only at longer time intervals than the inverse value of the sampling rate during the measurement of the flux density (B), and determines the actual choke current (I) from the actual measurement values of the flux density (B) taking into account the ascertained magnetic bias.

**8.** The device as claimed in claim 7, **characterized in that** the evaluation device (10) ascertains the magnetic bias of the choke (1) from the measurement values of the flux density (B) at the known choke current (I) at time intervals which are longer by at least a factor of 10 than the time intervals in which it determines the choke current from the actual measurement values of the flux density (B) taking into account the ascertained magnetic bias.

**9.** The device as claimed in claim 7 or 8, **characterized in that** a current sensor (12) which directly measures the choke current (I) at a sampling rate which is lower by at least a factor of 10 than that of the magnetic field sensor (9) is provided.

**10.** The device as claimed in one of claims 7 to 9, **characterized in that** the evaluation device (10) receives a signal from which it ascertains points in time at which the choke current (I) is zero or at which different choke currents ($I_1$, $I_2$) are in a known ratio in relation to one another.

**11.** The device as claimed in one of claims 7 to 10, **characterized in that** the evaluation device (10) comprises an event detector and, when a prespecified event is detected, repeats the process of ascertaining the magnetic bias of the choke (1).

**12.** The device as claimed in one of claims 7 to 11, **characterized in that** the magnetic field sensor (9) is a Hall sensor.

**13.** The device as claimed in one of claims 7 to 12, **characterized in that** a plurality of magnetic field sensors (9) are provided which consecutively measure the flux density (B) of the magnetic field (8) at a plurality of fixed locations in relation to the choke (1).

**14.** The device as claimed in one of claims 7 to 13, **characterized in that** the source for magnetic bias comprises a permanent magnet (4).

**15.** The device as claimed in one of claims 7 to 14, **characterized in that** at least one temperature sensor measuring the temperature of a core (2) of the choke (1) and/or of the source of the magnetic bias (6) and/or of the magnetic field sensor (9), and connected to the evaluation device (10) is provided, and **in that** the evaluation device (10) takes into account the temperature measured by the temperature sensor when ascertaining the magnetic bias and/or the actual choke current (I) from the actual measurement values of the flux density (B).

**Revendications**

**1.** Procédé de détermination d'un courant de bobine (I) à travers une bobine (1), une densité de flux (B) d'un champ magnétique (8) émanant de la bobine (1) étant mesurée continuellement avec une fréquence d'échantillonnage en un endroit fixe par rapport à la bobine (1) et le courant de bobine (I) actuel étant déterminé à partir des valeurs mesurées actuelles de la densité de flux (B), **caractérisé en ce qu'**une précontrainte magnétique de la bobine (1) est déterminée à partir des valeurs mesurées de la densité de flux (B) avec un courant de bobine (I) connu qui se produit durant le fonctionnement de la bobine (1), le courant de bobine (I) n'étant connu qu'à des intervalles de temps supérieurs à l'inverse de la fréquence d'échantillonnage lors de la mesure de la densité de flux (B), et **en ce que** le courant de bobine (I) actuel est déterminé à partir des valeurs mesurées actuelles de la densité de flux (B) en tenant compte de la précontrainte magnétique déterminée.

**2.** Procédé selon la revendication 1, **caractérisé en ce que** la précontrainte magnétique de la bobine (1) est déterminée à partir des valeurs mesurées de la densité de flux (B) avec le courant de bobine (I) connu dans des intervalles de temps qui sont plus grands d'au moins un facteur 10 à ceux auxquels est déterminé le courant de bobine à partir des valeurs mesurées actuelles de la densité de flux (B) en tenant compte de la précontrainte magnétique déterminée.

**3.** Procédé selon l'une des revendications précédentes, **caractérisé en ce que** la précontrainte magnétique de la bobine (1) est déterminée en utilisant les valeurs mesurées de la densité de flux (B) avec un courant de bobine (I) nul.

**4.** Procédé selon l'une des revendications précédentes, **caractérisé en ce que** la précontrainte magnétique de la bobine (1) est déterminée en utilisant les valeurs mesurées de la densité de flux (B) avec deux courants de bobine ($I_1$, $I_2$) différents qui présentent un rapport connu l'un à l'autre.

**5.** Procédé selon la revendication 3 ou 4, **caractérisé en ce que** les instants auxquels le courant de bobine (I) est nul ou auxquels les deux courants de bobine ($I_1$, $I_2$) différents qui présentent un rapport connu l'un à l'autre sont présents sont dérivés de conditions qui sont présentes durant le fonctionnement de la bobine (1).

**6.** Procédé selon l'une des revendications précédentes, **caractérisé en ce que** la température d'un noyau (2) de la bobine (1) et/ou d'une source de la précontrainte magnétique (6) de la bobine (1) et/ou d'un capteur de champ magnétique (9) utilisé pour mesurer la densité de flux magnétique est mesurée et prise en compte lors de la détermination de la précontrainte magnétique et/ou du courant de bobine (I) actuel à partir des valeurs mesurées actuelles de la densité de flux (B).

**7.** Arrangement comprenant une bobine (1), comprenant un capteur de champ magnétique (9) disposé en un endroit fixe par rapport à la bobine (1), lequel mesure continuellement, avec une fréquence d'échantillonnage, une densité de flux (B) d'un champ magnétique (8) émanant de la bobine (1), et comprenant un dispositif d'interprétation (10), qui détermine le courant de bobine (I) actuel à partir des valeurs mesurées actuelles de la densité de flux (B), **caractérisé en ce que** la bobine (1) possède une source pour une précontrainte magnétique et **en ce que** le dispositif d'interprétation (10) détermine une précontrainte magnétique de la bobine (1) à partir des valeurs mesurées de la densité de flux (B) avec un courant de bobine (I) connu qui se produit durant le fonctionnement de la bobine (1), le courant de bobine (I) n'étant connu qu'à des intervalles de temps supérieurs à l'inverse de la fréquence d'échantillonnage lors de la mesure de la densité de flux (B), et détermine le courant de bobine (I) actuel à partir des valeurs mesurées actuelles de la densité de flux (B) en tenant compte de la précontrainte magnétique déterminée.

**8.** Arrangement selon la revendication 7, **caractérisé en ce que** le dispositif d'interprétation (10) détermine la précontrainte magnétique de la bobine (1) à partir des valeurs mesurées de la densité de flux (B) avec le courant de bobine (I) connu dans des intervalles de temps qui sont plus grands d'au moins un facteur 10 à ceux auxquels il détermine le courant de bobine à partir des valeurs mesurées actuelles de la densité de flux (B) en tenant compte de la précontrainte magnétique déterminée.

**9.** Arrangement selon la revendication 7 ou 8, **caractérisé en ce qu'**un capteur de courant (12) est présent, lequel mesure directement le courant de bobine (I) avec une fréquence d'échantillonnage inférieure d'au moins un facteur 10 à celle du capteur de champ magnétique (9).

**10.** Arrangement selon l'une des revendications 7 à 9, **caractérisé en ce que** le dispositif d'interprétation (10) reçoit un signal à partir duquel il détermine les instants auxquels le courant de bobine (I) est nul ou auxquels des courants de bobine ($I_1$, $I_2$) différents présentent un rapport connu l'un à l'autre.

**11.** Arrangement selon l'une des revendications 7 à 10, **caractérisé en ce que** le dispositif d'interprétation (10) possède un détecteur d'événement et, lors de la détection d'un événement prédéfini, répète la détermination de la précontrainte magnétique de la bobine (1).

**12.** Arrangement selon l'une des revendications 7 à 11, **caractérisé en ce que** le capteur de champ magnétique (9) est un capteur à effet Hall.

**13.** Arrangement selon l'une des revendications 7 à 12, **caractérisé en ce que** plusieurs capteurs de champ magnétique (9) sont présents, lesquels mesurent continuellement la densité de flux (B) du champ magnétique (8) en plusieurs endroits fixes par rapport à la bobine (1).

**14.** Arrangement selon l'une des revendications 7 à 13, **caractérisé en ce que** la source de la précontrainte magnétique comporte un aimant permanent (4).

**15.** Arrangement selon l'une des revendications 7 à 14, **caractérisé en ce qu'**au moins un capteur de température est présent, lequel mesure la température d'un noyau (2) de la bobine (1) et/ou de la source de la précontrainte magnétique (6) et/ou du capteur de champ magnétique (9) et lequel est raccordé au dispositif d'interprétation (10) et **en ce que** le dispositif d'interprétation (10) tient compte de la température mesurée par le capteur de température lors de la détermination de la précontrainte magnétique et/ou du courant de bobine (I) actuel à partir des valeurs mesurées actuelles de la densité de flux (B).

**Fig. 1**

**Fig. 2**

**Fig. 3**

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 2876787 Y
- WO 2011029018 A2
- DE 10317215 A1
- DE 102011000980 A1
- DE 102010062237 A1
- JP S62163974 A
- DE 2827601